# EUROPEAN PATENT APPLICATION

(11) **EP 2 088 622 A2**
(43) Date of publication of application: **12.08.2009**
(21) Application number: 09001516.5
(22) Date of filing: 04.02.2009
(51) Int. Cl.: H01L 21/77

(54) **Method for forming an electronic device on a flexible metallic substrate and resultant device**

(30) Priority: 08.02.2008 US 28174
(71) Applicant: Carestream Health, Inc., Rochester, NY 14608-1733 (US)
(72) Inventor: Kerr, Roger S., Brockport, New York 14420 (US); Tredwell, Timothy John, Fairport, New York 14450 (US); Harland, Mark A., Hilton, New York 14468 (US); Murray, James T., Holley, New York 14470 (US)
(74) Representative: Emde, Eric

(57) **Abstract**

A method for forming an electronic device provides a metallic carrier having a retaining surface and secures a contact surface of a metallic substrate material against the retaining surface of the metallic carrier. The substrate is processed to form the electronic device thereon; and the metallic substrate material released from the metallic carrier, to yield the completed electronic device.

## Description

### FIELD OF THE INVENTION

This invention generally relates to electronic device fabrication and more particularly relates to a method for securing a metallic carrier to a metallic substrate, forming an electronic device on the substrate, and then removing the substrate from the carrier to yield the completed electronic device.

### BACKGROUND OF THE INVENTION

Thin-film transistor (TFT) devices are widely used in switching or driver circuitry for electro-optical arrays and display panels. TFT devices are conventionally fabricated on rigid substrates, typically glass or silicon, using a well-known sequence of deposition, patterning and etching steps. For example, amorphous silicon TFT devices require deposition, patterning, and etching of metals, such as aluminum, chromium or molybdenum; of amorphous silicon semiconductors; and of insulators, such as SiO2 or Si3N4 onto a substrate. The semiconductor thin film is formed in layers having typical thicknesses ranging from several nm to several hundred nm, with intermediary layers having thicknesses on the order of a few microns, and may be formed over an insulating surface that lies atop the rigid substrate.

The requirement for a rigid substrate has been based largely on the demands of the fabrication process itself. Thermal characteristics are of particular importance, since TFT devices are fabricated at relatively high temperatures. Thus, the range of substrate materials that have been used successfully is somewhat limited, generally to glass, quartz, or other rigid, silicon-based materials.

TFT devices can be formed on some types of metal substrates, allowing some measure of flexibility in their fabrication. However, problems such as thermal expansion mismatch between substrate and carrier materials that support the substrate during fabrication make metal substrates more difficult to employ in many applications.

TFT fabrication onto flexible substrates generally requires that the substrate be held on a carrier of some type during the various stages of layer deposition. One of the more important functions of such a carrier is providing dimensional stability to the flexible substrate. Thus, for example, a rigid glass carrier is conventionally provided. However, metallic substrates and glass exhibit significant differences in their coefficients of thermal expansion (CTE). Excessive stress during heating or cooling cycles can shatter glass or can cause a metal substrate to release from a glass carrier prematurely, losing its dimensional stability.

Thus, it can be seen that although there has been great interest in developing and expanding the use of metals as flexible substrates, compatibility with a conventional glass carrier imposes some constraints on substrate material type. For this reason, there is a need for alternate carrier materials and techniques that can be employed for TFT fabrication onto flexible metallic substrates.

### SUMMARY OF THE INVENTION

An object of the present invention is to provide a method for forming an electronic device comprising providing a metallic carrier having a retaining surface; providing a metallic substrate having a contact surface; securing the contact surface against the retaining surface; processing the substrate to form the electronic device thereon; and releasing the metallic substrate material from the metallic carrier.

A feature of the present invention is that it provides an electronic device fabricated onto a flexible metallic substrate. The present invention enables fabrication onto thin sheets of stainless steel, for example.

An advantage of the present invention is that it provides a carrier suitable for processing a flexible substrate at high temperatures, wherein the carrier can also be fabricated in such a way as to adjust its CTE characteristics.

These and other objects, features, and advantages of the present invention will become apparent to those skilled in the art upon a reading of the following detailed description when taken in conjunction with the drawings wherein there is shown and described an illustrative embodiment of the invention.

### BRIEF DESCRIPTION OF THE DRAWINGS

While the specification concludes with claims particularly pointing out and distinctly claiming the subject matter of the present invention, it is believed that the invention will be better understood from the following description when taken in conjunction with the accompanying drawings.
FIG. 1 is a side view of an electronic device formed on a flexible substrate.
FIG. 2 is a perspective view showing a flexible metal substrate mounted on a carrier.
FIG. 3 is a cross-sectional side view showing a flexible metal substrate mounted on a carrier using an intermediate binder material.
FIG. 4 is a perspective view showing a flexible substrate partially in position against a carrier.

### DETAILED DESCRIPTION OF THE INVENTION

It is to be understood that elements not specifically shown or described in the following detailed description may take various forms well known to those skilled in the art. Figures given in this application are representative of overall spatial relationships and arrangement of layers for deposition onto a substrate and may not be drawn to scale.

In embodiments of the present invention, a flexible metallic substrate such as a stainless steel foil is laminated to a metal carrier by means of heat, pressure, and vacuum, or some combination of these conditions. A reflowable plastic binder material is used between the substrate and the carrier. This plastic binder material may be Teflon or a similar material that reflows when heated to near or above the temperature that is used to fabricate devices. The term "flexible" refers generally to metallic sheet materials that are thinner than about 1.5 mm.

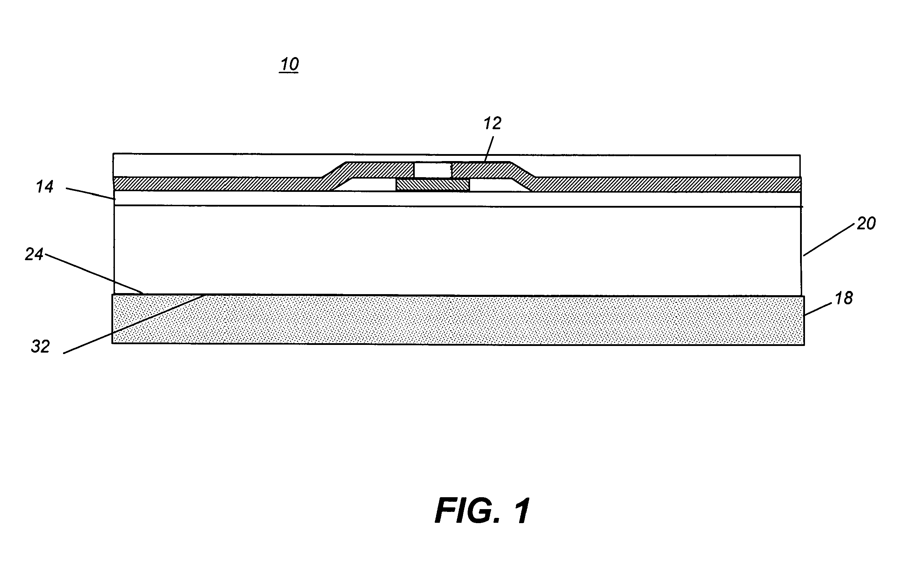

Referring to Figure 1, there is shown an electronic device 10 formed according to the present invention. A thin-film electronic component or device 12, such as a conductor, a thin-film transistor, a diode, or other component, is formed onto a flexible metallic substrate 20 such as a metal foil. A layer 14 of silicon nitrite, for example, may be applied between device 12 and substrate 20, to provide a barrier against diffusion of impurities from substrate 20 into device 12. During device fabrication, substrate 20 is provided on, deposited on, laminated to, or otherwise attached to, a carrier 18 that provides dimensional stability for substrate 20 over the range of processing temperatures and conditions required for thin-film device manufacture.

The apparatus and method of the present invention provide carrier 18 having properties that are favorable for TFT fabrication onto a flexible substrate of stainless steel or other metal. By matching, or substantially matching, the coefficient of thermal expansion (CTE) of the flexible substrate, the apparatus and method of the present invention provide a carrier that adapts to the substrate and holds the substrate in position during fabrication processing without adverse effects due to the changing temperature range.

In some embodiments of the present invention, carrier 18 may be made from a stainless steel material. In other embodiments, a different metal may be used for carrier 18, provided that it closely matches the CTE of substrate 20. The CTEs of the carrier and the substrate can be considered substantially equal if they are within about 25% of each other, more preferably within about 10% of each other.

With various embodiments of the present invention, a high structural rigidity of the carrier material can be obtained along with favorable CTE characteristics, with advantages in both cost and performance. Carrier 18 of the present invention is intended to be reused any number of times, as determined by the various materials used and fabrication conditions encountered. In some embodiments, substrate 20 itself can first be formed by deposition onto carrier 18, followed by fabrication of the TFT device.

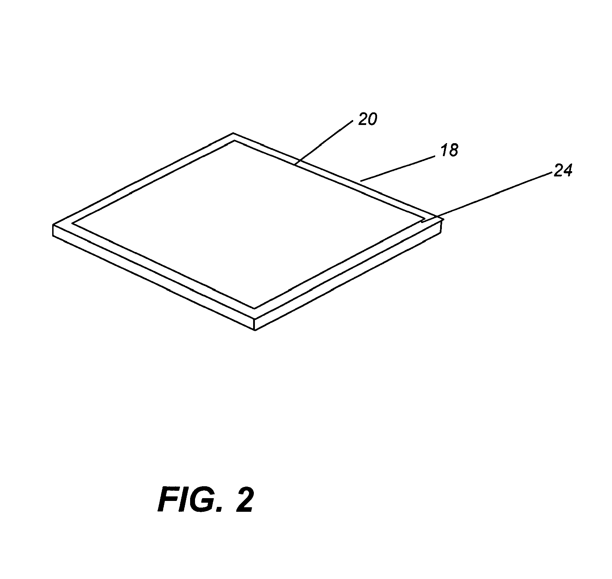

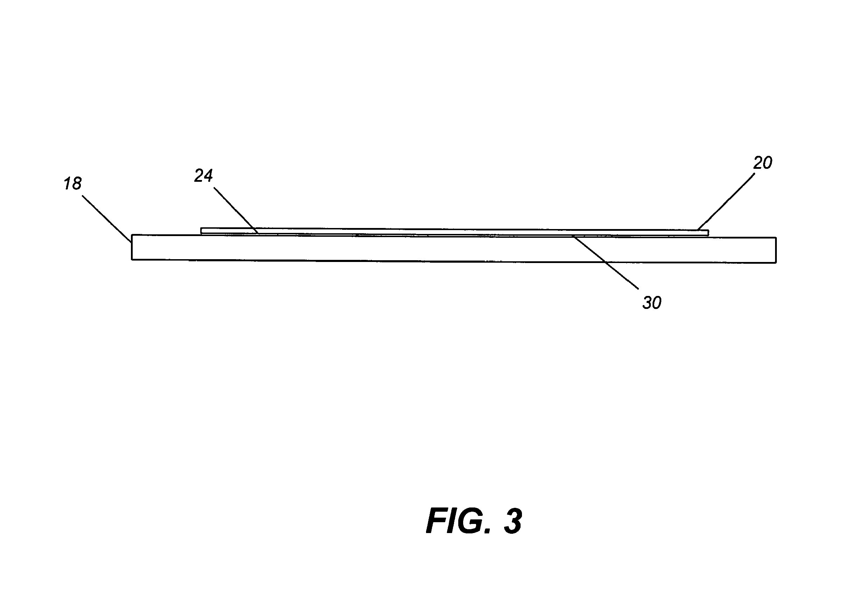

The perspective view of Figure 2 shows substrate 20 secured against a retaining surface 24 of carrier 18 prior to electronic device fabrication. The cross-sectional view of Figure 3 shows an embodiment in which substrate 20 is secured by being laminated to retaining surface 24 of carrier 18 using a reflowable plastic binder material 30 that is applied between them. Binder materials can be selected from a range of plastic substances, based on desired properties. Some plastic binder materials of special interest include polyimide, as noted earlier, and polytetrafluoroethylene (PTFE) or poly(perfluoro-alboxy)fluoropolymer (PFA), known commercially as Teflon®, sold by DuPont, Inc.

Still other exemplary binder plastic materials that could be used for lamination include, but would not be limited to, heat-stabilized polyethylene terephthalate (HS-PET), polyethylenenapthalate (PEN), polycarbonate (PC), polyarylate (PAR), polyetherimide (PEI), polyethersulphone (PES), polyimide (PI) including Kapton®, Teflon® poly(perfluoro-alboxy)fluoropolymer (PFA), poly(ether ether ketone) (PEEK), poly(ether ketone) (PEK), poly(ethylene tetrafluoroethylene)fluoropolymer (PETFE), and poly(methyl methacrylate) and various acrylate/methacrylate copolymers (PMMA). Suitable plastics for use as binder may also include various cyclic polyolefins, ARTON fabricated by JSR Corporation, Zeonor made by Zeon Chemicals L.P., and Topas made by Celanese AG. Other lower-temperature plastic substrates can also be used, including: ethylene-chlorotrifluoro ethylene (E-CTFE), marketed as HALAR from Ausimont U.S.A., Inc., ethylene-tetra-fluoroethylene (E-TFE) sold under the trademark TEFZEL by Dupont Corporation, poly-tetrafluoro-ethylene (PTFE), fiber glass enhanced plastic (FEP), and high density polyethylene (HDPE). Plastics that allow melting and undergo reflow at high temperatures can be particularly advantageous for their "self-laminating" capabilities.

A number of deposition methods are available for applying a binder material to retaining surface 24 or contact surface 32 or both. These include coating techniques of various types, such as spraying and inkjet printing application, for example. In one embodiment, thin sheets of Teflon material may be positioned between substrate 20 and carrier 18 and heat application causes reflow sufficient to secure the substrate in position. Lamination of a reflowable material, such as a reflowable plastic material, from a release sheet could also be used for binder material deposition.

Heat and pressure provide one type of lamination energy. Other lamination methods may use heat alone, pressure alone, or solvents or other materials with binder material 30. Alternative methods for lamination may include solvent softening techniques. Radiation could alternately be applied for lamination and delamination.

Other alternatives to lamination for securing contact surface 32 against retaining surface 24 include the use of adhesives and methods such as diffusion bonding. Diffusion bonding can use heat and pressure alone or can use other intermediary binding materials, such as solder, along with heat and pressure.

Delamination can be performed in a number of ways, using heat or chemicals for example. In many embodiments, the process for releasing the substrate from the carrier uses the same type of energy that was used for the process of securing the substrate to the carrier. For example, when using reflowable plastic materials, heat can be used for lamination as well as for subsequent delamination. Localized cooling of the substrate or of the carrier can be used as a method for release in some embodiments. Cooling takes advantage of thermal contraction/expansion characteristics of the metal carrier and substrate.

Where an epoxy or other adhesive is used, heat or electromagnetic energy can be applied to weaken the adhesive bond sufficiently for release of substrate 20 from carrier 18 following component fabrication. For example, Epo-Tek 353ND epoxy, available from Epoxy Technology, Inc., Billerica, MA, and similar epoxies can have relatively low glass transition temperatures when under extended periods of heat application and can have degradation temperatures at which bond strength significantly decreases. Alternately, peeling could be used for delamination, including methods that peel using a metal or metal wire skive, for example. Radiation can be used to fix or soften binder material 30 between carrier 18 and substrate 20.

### Example 1

In one embodiment, the material used for carrier 18 is a stainless steel sheet of approximately 50.8 mm thickness. Substrate 20 is a stainless steel foil of approximately 0.762 mm thickness.

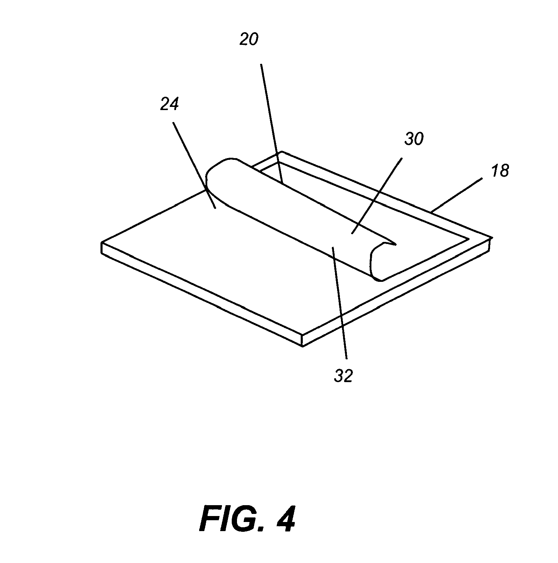

Given these materials, TFT fabrication processing using a flexible substrate 20 is as follows:
1. Surface preparation. In this step, shown in the perspective view of Figure 4, a thin Teflon (PTFE) coating is applied as binder material 30 to a contact surface 32 of flexible substrate 20. This can be applied using any suitable deposition technique. A thickness of between about 0.127 to 1.27 mm may be sufficient for a smaller substrate 20; this thickness can vary depending on the desired stiffness and area of flexible substrate 20.
2. Positioning. Substrate 20 is positioned so that it is centered about retaining surface 24 on carrier 18.
3. Lamination. Lamination of substrate 20 to carrier 18 is performed by applying heat and pressure to achieve the flow temperature (Tg) of the PTFE binder material 30, approximately 300 degrees C. The PTFE material softens, reflows, and bonds contact surface 32 to retaining surface 24. Entrapped air between carrier 18 and contact surface 32 of the substrate is forced out as the heat and pressure are applied.
4. Processing. Substrate 20 is then processed to form one or more electronic devices 10 (Figure 1).
5. Delamination. Heat is then used once again to cause a reflow of the PTFE material at approximately 300 degrees C. Substrate 20 can then be released from the surface of carrier 18.

The steps given for this example admit any of a number of variations. For example, the thickness as well as the composition of the applied binder material 30 can be adapted suitably for substrate 20 and carrier 18 conditions. A relatively pure Teflon material can be used; however, a composition that includes Teflon with particulate, fibrous, or other filler materials could alternately be used, where the particulate additive provides improved behavior, temperature range, or other condition.

Outside of retaining surface 24, the reflowable plastic material acts as a barrier to prevent entrapment of air or other gases between the interfacing surfaces of substrate 20 and carrier 18. Reheating the Teflon binder intermediate material then allows release of substrate 20 from carrier 18. In some embodiments, binder material 30 remains deposited on substrate 20 after its removal from the carrier 18 surface, serving as a dielectric layer, for example.

### Example 2

In another embodiment, an adhesive temporarily secures substrate 20 against carrier 18. Steps for TFT fabrication are then as follows:
1. Securing substrate 20 to carrier 18. Flexible substrate 20 is adhesively affixed to carrier 18. This is done by coating an adhesive having suitable tackiness or peel strength onto either substrate 20 or carrier 18 or both. Pressure or combined heat and pressure can be used to adhere substrate 20 in place. Entrapped air is forced out from between the carrier and substrate.
2. Planarization. The desired surface roughness for TFT deposition can be on the order of less than 0.2 to 0.3 microns peak-to-peak or better in some applications. Planarization materials can be added to the exposed substrate surface to achieve this smoothness level.
4. Forming electrical isolation layer. As a final surface preparation step for conditioning the surface of the substrate, which may be optional, an electrical isolation layer is deposited on top of the planarization layer. A suitable isolation layer material can be Si02, SiNx, SiON, or some combination of these materials. This is typically in the thickness range from about 0.5 to 1.5 µm.
5. Forming TFT elements. Following preparation of the flexible substrate 20 surface, the lay-down of TFT elements can begin. This typically requires depositing a layer of thin-film semiconductor material onto the substrate, then forming a pattern by selective removal of portions of the semiconductor material. This procedure uses processes that are well known in the art of component fabrication for lay-down of gate, source, and drain components and other supporting layers.
6. Release from carrier 18. Heat, cooling, radiation, or solvent can be used to free substrate 20 from adhesion to the surface of carrier 18, allowing release of carrier 18 from substrate 20. Alternatively, in some applications, substrate 20 can be cut through around the formed TFT elements, such as by laser cutting, to facilitate removal of a portion of the substrate with TFT elements. The remainder of the substrate then remains attached to the carrier. Once separated by whatever means, substrate 20 can be laminated or applied to some other surface or allowed to cool.

The method and apparatus of the present invention enable the use of a number of flexible materials as substrates for electronic devices, including metals such as stainless steel and nickel, for example.

In matching substrate 20 to carrier 18, it is useful to observe the Coefficients of Thermal Expansion (CTE) between the two materials. With the apparatus and method of the present invention, it is possible to design and fabricate carrier 18 and substrate 20 of the same metals or of metals that have compatible CTE characteristics. When CTE values are closely matched, only a small amount of binder material or adhesive is needed in order to secure the substrate to the carrier. This simplifies both the step of securing the substrate to the carrier and the step of releasing the substrate.

Various metals and alloys could be used as substrate 20 or as carrier 18. This includes, for example, stainless steel, aluminum, copper, and other metals. Series 300 stainless steel types, generally nonmagnetic, can be particularly advantageous.

The invention has been described in detail with particular reference to certain preferred embodiments thereof, but it will be understood that variations and modifications can be effected within the scope of the invention as described above, and as noted in the appended claims, by a person of ordinary skill in the art without departing from the scope of the invention. For example, deposition methods can be particularly advantageous where it is desirable to apply pressure, without heat, for mounting substrate 20 to carrier 18.

The electronic device formed on substrate 20 can be used to provide signals to or from any of a number of different types of components and would have particular applications for image display pixels or image sensing pixels. For example, the electronic device formed on the substrate 20 surface can be coupled with a corresponding liquid crystal pixel, light-emitting diode pixel, or organic light-emitting diode pixel for display, for example. For image sensing, the electronic device formed on the substrate 20 surface can be coupled with a stimulable phosphor pixel or with another type of sensor pixel, including a biological detector.

Thus, what is provided is a method for mounting a flexible metal substrate to a carrier for forming an electronic device on the substrate.

### PARTS LIST

- 10: electronic device
- 12: thin-film electronic component or device
- 14: barrier layer
- 18: metallic carrier
- 20: flexible metallic substrate
- 24: retaining surface on carrier 18
- 30: binder material
- 32: contact surface on substrate 20

### SUMMARY OF THE INVENTION:

1. A method for forming an electronic device comprising:
   providing a metallic carrier having a retaining surface;
   providing a flexible metallic substrate having a contact surface; securing the contact surface against the retaining surface;
   processing the substrate to form the electronic device thereon; and releasing the metallic substrate material from the metallic carrier.
2. The method of 1 wherein securing the contact surface against the retaining surface comprises
   applying a plastic binder material to either the retaining surface of the carrier or the contact surface of the substrate, or both; and
   attaching the substrate to the carrier by laminating.
3. The method of 2 wherein laminating comprises applying heat to the carrier or the substrate or both.
4. The method of 2 wherein laminating comprises applying pressure to the carrier and the substrate.
5. The method of 3 wherein heating causes the plastic binder to undergo a reflow condition.
6. The method of 1 wherein releasing the metallic substrate from the carrier comprises heating the carrier surface, heating the substrate, or both.
7. The method of 1 wherein securing the contact surface comprises irradiating the substrate and carrier over a band of wavelengths.
8. The method of 7 further comprising applying electromagnetic radiation for releasing the substrate from the carrier.
9. The method of 1 wherein the substrate is of the same metal as the carrier.
10. The method of 1 wherein the carrier is an alloy.
11. The method of 1 wherein securing the contact surface comprises using diffusion bonding.
12. The method of 1 wherein releasing comprises cooling the carrier surface, cooling the substrate, or both.
13. The method of 2 wherein the plastic binder material comprises polytetrafluoroethylene (PTFE).
14. The method of 2 wherein the plastic binder material is taken from the group consisting of heat-stabilized polyethylene terephthalate (HS-PET), polyethylenenapthalate (PEN), polycarbonate (PC), polyarylate (PAR), polyetherimide (PEI), polyethersulphone (PES), polyimide (PI), Teflon poly(perfluoro-alboxy)fluoropolymer (PFA), Kapton, poly(ether ether ketone) (PEEK), poly(ether ketone) (PEK), poly(ethylene tetrafluoroethylene)fluoropolymer (PETFE), poly(methyl methacrylate), acrylate/methacrylate copolymers (PMMA), cyclic polyolefins, ethylene-chlorotrifluoro ethylene (E-CTFE), ethylene-tetra-fluoroethylene (E-TFE), fiber glass enhanced plastic (FEP), and high density polyethylene (HDPE).
15. The method of 2 wherein laminating comprises irradiating the substrate and carrier over a band of wavelengths.
16. The method of 15 further comprising irradiating the substrate and carrier for delamination.
17. The method of 1 wherein releasing comprises cooling the carrier surface, cooling the substrate, or both.
18. A method for forming an electronic device comprising:
   providing a metallic carrier having a retaining surface;
   providing a metallic substrate having contact surface;
   applying an adhesive to the retaining surface, or to the contact surface, or to both surfaces;
   adhering the metallic substrate to the metallic carrier;
   processing the metallic substrate to form the electronic device thereon; and
   releasing the metallic substrate from the metallic carrier.
19. The method of 18 wherein releasing the metallic substrate from the metallic carrier comprises heating the substrate, heating the carrier, or both.
20. The method of 18 wherein applying an adhesive comprises applying an epoxy.
21. An electronic device formed in accordance with the method of 1.
22. An electronic device formed in accordance with the method of 18.

## Claims

1. A method for forming an electronic device comprising:
providing a metallic carrier having a retaining surface;
providing a flexible metallic substrate having a contact surface;
securing the contact surface against the retaining surface;
processing the substrate to form the electronic device thereon; and
releasing the metallic substrate material from the metallic carrier.

2. The method of claim 1 wherein securing the contact surface
against the retaining surface comprises applying a plastic binder material to either the retaining surface of the carrier or the
contact surface of the substrate, or both; and attaching the substrate to the carrier by laminating.

3. The method of claim 1 wherein releasing the metallic substrate from the carrier comprises heating the carrier surface, heating the substrate, or both.

4. The method of claim 1 wherein securing the contact surface comprises irradiating the substrate and carrier over a band of wavelengths.

5. The method of claim 1 wherein the substrate is of the same metal as the carrier.

6. The method of claim 1 wherein the carrier is an alloy.

7. The method of claim 1 wherein securing the contact surface comprises using diffusion bonding.

8. The method of claim 1 wherein releasing comprises cooling the carrier surface, cooling the substrate, or both.

9. The method of claim 1 wherein releasing comprises cooling the carrier surface, cooling the substrate, or both.

10. A method for forming an electronic device comprising:
providing a metallic carrier having a retaining surface;
providing a metallic substrate having contact surface;
applying an adhesive to the retaining surface, or to the contact surface, or to both surfaces;
adhering the metallic substrate to the metallic carrier;
processing the metallic substrate to form the electronic device thereon; and
releasing the metallic substrate from the metallic carrier.

11. The method of claim 10 wherein releasing the metallic substrate from the metallic carrier comprises heating the substrate, heating the carrier, or both.

12. The method of claim 10 wherein applying an adhesive comprises applying an epoxy.
